# EUROPEAN PATENT APPLICATION

(11) **EP 1 935 842 A1**
(43) Date of publication of application: **25.06.2008**
(21) Application number: 06077308.2
(22) Date of filing: 22.12.2006
(51) Int. Cl.: B81C 3/00, B01J 19/00, B01L 3/00, B29C 65/00, B32B 3/26, B32B 27/00, B32B 38/18

(54) **Multilayer device and apparatus and method for manufacturing such a device**

(71) Applicant: Nederlandse Organisatie voor toegepast- natuurwetenschappelijk onderzoek TNO, 2628 VK Delft (NL)
(72) Inventor: Smulders, Edwin J.T., 5672 SG Nuenen (NL); Veninga, Erik Peter, 5673 LW Nuenen (NL)
(74) Representative: van Loon, C.J.J.

(57) **Abstract**

In a method of manufacturing a multilayer device exposed surfaces of a first and second layer are forced together after applying adhesive. The first layer or stack of layers bent along its exposed surface and the exposed surface is brought into initial contact at a point or line of tangency along the bend. A temporally increasing force is exerted between the first and second layer through point or line of tangency, thereby reducing the resilient deformation of the first layer, until the bend has been forced out.

## Description

The invention relates to a multilayer device, and in particular to a microfluidic device and to a method of manufacturing such a multilayer device.

US patent application No 2002176804 describes microfluidic devices and their manufacture. Generally microfluidic devices are constructed to process fluids on a small scale. This requires small sized conduits, sensors, valves etc. Microfluidic devices have been manufactured from stacks of polymer layers wherein spatial structures such as grooves in the layer or holes through the layer have been provided. On these layers electrical structures such conductors and resistors have been provided to realize sensors, heater circuits etc. This method of manufacturing significantly reduces material costs. In fact, the majority of the remaining device cost is due to the cost of the manufacturing process, so that it is desirable to reduce the costs of this process.

Once structures have been defined in the layers, the layers are joined to form a device, wherein fluid channels are defined by the holes and the grooves surrounded by material from the layers. Joining is an important step, as it has to ensure leak free and permanent sealing of the channels. Also the method of joining should not damage the structures defined in the layers.

EP886306, which belongs to the art of manufacturing imaging devices such as LCD's a method of joining layers is known for obtaining improved optical properties. In this method, adhesive is applied to one of the layers (typically a glass plate, or a semiconductor substrate). The layers are then placed over one another under vacuum, with the adhesive on one layer facing the other layer. Spacers are used to maintain a small separation between the layers. Mechanical pressure is then applied to the centre of one of the layers using a mechanical pin or rod, so as to deform the layer to the extent that it contacts the other layer. Subsequently the spacers are removed, with the effect that the layer flattens itself against the other layer.

One problem with this technique is that it has to be applied in vacuum. When it is applied under normal atmospheric pressure there is a risk that gas bubbles will be trapped in between the layer. In microfluidic devices such trapped bubbles can lead to malfunctioning due to leaks, or even to delamination. Also the spacers needed in this technique limit the useful area on the device.

The electrical structures are conventionally defined on the layers by adding electrically active, material on top of the layers. As used herein electrically active materials include such as conductor material, semi-conductor materials, resistive materials, or combinations thereof. Electrically active materials may be used to create , resistors, capacitors, actuators, sensing elements etc..

Another problem with known microfluidic device manufacture is that the application of electrical material on top of the layers limits the possibilities construction of electrical elements. Moreover many manufacturing steps (e.g. lithographic patterning steps) are needed when complex devices need to be manufactured.

Among others it is an object of the invention to provide for simplifications in the manufacture of multi-layer devices such as microfluidic devices.

A method according to claim 1 is provided. Herein at least one of the layers is initially resiliently bent and the layers are pushed together so that the layers first make contact at a single point or line of tangency and the resilient bend is subsequently gradually pushed out by forcing the layers against each other. Thus the layers can be joined reliably. No vacuum is needed between the layers, so that the layers may be held by suction against their surfaces that face away from the other layer.

Preferably electrically conductive, semi-conductive and/or resistive material is provided in a depression of at least one of the layers. This may improve the reliability of joining of the layers when they are forced against each other. Independent of this it makes it possible to reduce feature size and the minimum distance from electrically active material to the opposite surface. This is especially advantageous when the electrically active material has to be provided at close distance between gas compartments on opposite sides of the layers.

These and other objects and advantageous aspects will become apparent from a description of exemplary embodiments using the following figures.
- Figure 1: shows an example of layers used in a microfluidic device
- Figure 2: shows a cross-section of a layers used in a microfluidic device
- Figure 3: illustrates an apparatus for joining layers
- Figure 4a-c: illustrates layers during a joining process
It is proposed to manufacture gas processing devices as microfluidic devices by defining structures in and/or on layers and subsequently joining the layers. Such a microfluidic device may contain a combination of functional elements such as heaters, valves, flow sensors, flow controllers, mixers and reaction chambers. A chamber or channel is formed by defining a depression in at least one layer and attaching another layer to that layer, closing of the top of the depression. A fluid heater may constructed by providing electrically resistive material an a layer adjacent a channel or chamber. A valve may be constructed for example using a channel adjacent a flexible membrane that borders a chamber containing a gas that can be heated using a heating element. A flow sensor may be constructed for example using a channel adjacent a succession of a temperature sensor (e.g. a temperature dependent resistor, such as a resistor with a positive or negative temperature coefficient) a heater (e.g. a heater resistor) and another temperature sensor. Herein the effect of heating with the heater on temperature can be used as a measure of flow speed. A flow controller can be constructed from a flow sensor along a channel that is coupled in series with a valve, in combination with a feedback loop to control the valve dependent on a difference between measured flow and desired flow. A mixer may be constructed from a plurality of flow controllers with outputs coupled to a common channel or chamber.

Such devices can be realized by defining grooves in layers, to serve as channels or chambers, by providing layers to serve as flexible membranes and providing layers with electrical elements such as resistances, temperature dependent resistances, connecting wiring etc. and joining such layers. As used herein resistances are elements with a resistivity that is at least so low that it allows functionally significant currents to flow, i.e. currents that will be measured in operation, used to define bias voltages or currents or used to create a physical effect such as heating. The term resistive material has a similar meaning. A matrix of repeating patterns of structures can be defined on the layers and after stacking the layers by joining the stack can be partitioned into devices. A number of functional elements, in fluidic contact with each other via channels may be realized within each device..

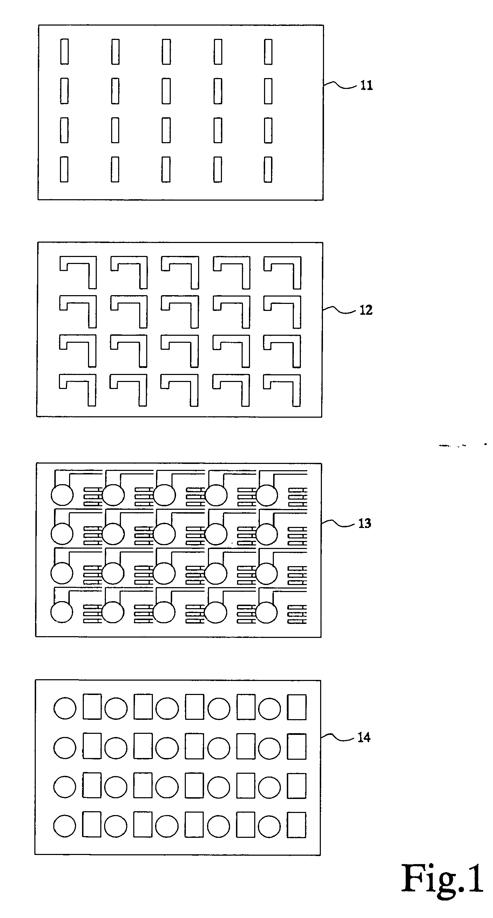

Figure 1 illustrates layers used during manufacture of a microfluidic device. The main surface of the layers (top view) is illustrated. In a first layer 11 a matrix of grooves 110 is constructed, for example by milling, cutting, moulding, laser ablation, etching or the like. Within each groove a hole through the layer may be constructed with a similar technique. A second layer 12 comprises a matrix of grooves and holes with a different shape, which can be manufactured in a similar way. During manufacture second layer 12 will be joined to first layer 11, so that the holes in the second layer 12 connect the grooves in the second layer to the grooves in the first layer. On a third layer 13 a number of matrixes of electrical elements is deposited, such as for example a matrix of temperature dependent resistances, heater resistances, and conductors. During manufacture third layer 13 will be joined to second layer 12. In a fourth layer 14 holes are defined to serve as chambers for gas for example, or as vias for electrical connections. During manufacture fourth layer 14 will be joined to third layer 13. A fifth layer (not shown) serves as cap for the chambers and contains holes as via's for connections. During manufacture the fifth layer will be joined to fourth layer 14.

In this example of the microfluidic device the device contains a combination of a valve and a gas flow sensor manufactured by stacking a plurality of layers, wherein the conduit for the valve and the conduit for the gas flow sensor are defined by a same layer, and wherein a heating element and a temperature sensor for the gas flow sensor are printed on the flexible layer that provides the flexible wall of the chamber of the valve.

By using the flexible layer both as a flexible layer for the valve and as a base for the heater and sensor, the number of steps in the manufacture of the device can be reduced. As described, preferably, the heating element of the valve is also printed in and/or on the flexible layer. Alternatively different layers with electrical elements may be used, for example in order to realize more complex devices or to speed up manufacturing.

The layers can be of polymer material, such as PI (polyimide), PET (Polyethylene terephthalate), PC (Polycarbonate), PEEK (Polyetheretherketone), PMMA (Polymethylmethaacrylate), etc.

The layers need not all be of the same material. A layer that defines flexible membranes may be thinner for example and/or made of a different material.

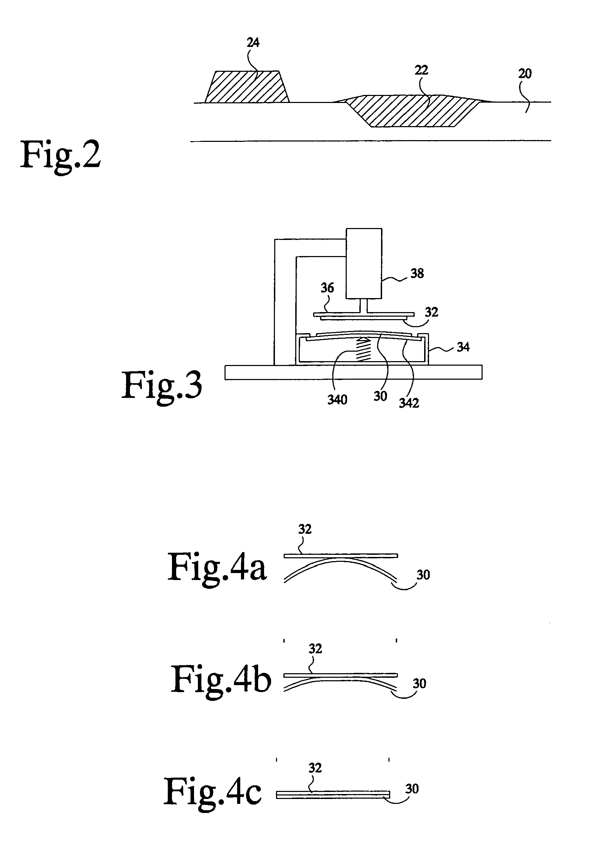

Figure 2 illustrates an embodiment of a layer 20 with electrical structures (not to scale). In this embodiment depressions are defined in the layer 20 and electrically resistive material 22 (e.g. a compound containing electrically resistive particles) is deposited in the depressions. Alternatively, or in addition, structures 24 containing such material may be defined on a flat layer portion, for example by printing or by photolithographic etching. Instead of resistive material, other electrically active material may be deposited, such as conductive material or semi-conductor material or mixtures thereof. The advantage of using depressions is that thinned portions of the layer can be defined for example to provide more flexibility in a resilient wall of a chamber, or to provide for a faster reaction to heating by a heater in the depression or faster sensing of temperature changes. Another advantage is that the depressions serve as an 'embedded' mask or stencil for the printing of the material 22. This method enables the creation of finer structures (e.g. with structures with widths smaller than 100um) than conventional printing techniques (which are limited to structures of at least 100um). The depressions can be realized by any convenient method, such as local etching, milling laser ablation, embossing or moulding techniques etc. The depressions may be for example half as deep as the layer is thick or even deeper to provide for close proximity to the opposite face of the layers (of course if less proximity suffices less deep depressions may be used). Depressions of 20 micron deep in 30 micron thick layers may be used for example. Use of depressions has the advantage that smaller features can be defined and that the distance between the electrically active material and the furthest surface of the layers can be increased. In addition, less electrically active material extends above the surface, thus reducing problems such as trapping of gas when the layers are joined.

Figure 3 illustrates an apparatus for joining layers 30, 32. The apparatus comprises a first holding assembly 34, a second holding assembly 36 and an actuator 38. Second holding assembly 36 is attached to actuator 38. First holding assembly 34 comprises a resilient element 340, such as a spring, a piston etc and an elastically deformable table 342.

In operation, first holding assembly 34 serves to hold a first layer 30 of a multilayer device. Second holding assembly 36 serves to hold a second layer 32, so that surfaces of the first and second layer 30, 32 face each other. Although a description will be given in terms of single layers it should be understood that the description also applies if a stack of layers is used instead of single layers; also it should be understood that the first and second layer in figure 3 can be any of the layers described in the preceding or another layer.

An adhesive is applied to at least one of the facing surfaces. Suitable adhesives for joining layers are known per se. In a embodiment the adhesive is applied by first applying the adhesive to an auxiliary surface (not shown) and subsequently pushing second holding assembly 36 with second layer 32 thereon against the auxiliary surface. In a further embodiment second layer 32 contains deepened structures such as channels. In this further embodiment this method of applying adhesive ensures that no adhesive is applied in the structures. However, alternatively other techniques of applying adhesives may be used.

First layer 30 is held on elastically deformable table 342. In an embodiment first layer 30 is held by suction force. In a first further embodiment holes (not shown) are provided in elastically deformable table 342 and a pump (not shown) is coupled to a chamber underneath elastically deformable table 342. Above first layer a gas pressure higher than the pressure in the chamber is maintained. In an alternative embodiment elastically deformable table 342 comprises a top layer with holes provided on top of a layer with grooves from a perimeter of elastically deformable table 342 to the holes. In this embodiment the perimeter is coupled to a pump not shown. Thus, no surface on first layer 30 need be sacrificed for holding first layer 10. It should be appreciated that this method of holding first layer 30 is useful only if no vacuum is required in the space between first layer 30 and second layer 32. As an alternative other methods of holding first layer may be used, such as mechanical attachment, temporary gluing, holding by gravity etc.

Second layer 32 is held on a rigid table on second holding assembly. 36. In an embodiment second layer 32 is held by suction force. A similar construction for holding may be used as in first holding assembly 34.

First and second layer 30, 32 are aligned with each other, so that the location of corresponding structures on the layers coincide. Alignment may be performed for example by measuring the position of structures or reference marks on the layers 30, 32 when attached to first and second holding assemblies 34, 36 and displacing the first and second holding assemblies 34, 36 relative to each other until the measurements indicate alignment.

Resilient element 340 exerts a force on a central region of elastically deformable table 342 in a direction of second layer 32. The central region may be point shaped or line-shaped (e.g. along a diameter of elastically deformable table 342. Away from the central region edges of elastically deformable table 342 are attached to (or at least withheld by) withholding elements (e.g. projections) of first holding assembly 34 that act in a direction opposite the direction of the force exerted by resilient element 340. Resilient element 340 is constructed so that the force is sufficient to deform the combination of first layer 30 and elastically deformable table 342. As a result the combination of first layer 30 and elastically deformable table 342 is deformed so that it acquires a curved surface with a central point, or line closest to second layer 32.

Initially the facing surfaces of the layers 30, 32 are spatially separated from one another. Subsequently actuator 340 moves second holding assembly 16 towards first holding assembly 34. As a result the surface of second layer 32 first comes into contact with the surface of first layer 30 at its central point or line. Subsequently actuator 340 gradually moves second holding assembly 36 further towards first holding assembly 34. As a result of the movement the deformation is gradually pushed out of first surface 30 and an increasingly larger part of second layer 32 comes into contact with the surface of first layer 30.

Figures 4a-c illustrate the layers during contact, with exaggerated deformation. Figure 4a shows the layers at initial contact. Figure 4b shows the layers after further relative movement of the layers. Figure 4c shows the layers after yet further relative movement of the layers.

As will be appreciated the apparatus provides for an arbitrarily controllable speed of expanding the area wherein the surfaces of the layers 30, 32 are in contact. Further movement of the second layer towards the first layer results in increasing contact area. Thus, the speed can be selected sufficiently slowly to prevent trapping of gas bubbles between the layers.

Although a specific embodiment of the apparatus has been schematically illustrated, it should be appreciated that alternative constructions are possible. As an example, instead of a combination of resiliently deformable table 342 and a resilient element 340, a pre-deformed resiliently deformable table may be used, which assumes a curved shape when no force is exerted and is flattened when a force is exerted, or such a curved shape may be realized by pre-tensioning the resiliently deformable table 342 in first holding assembly 34.

As another example, although an embodiment has been discussed wherein the second layer 32 is held on a rigid table, it should be understood that alternatively second layer 32 could be held on a resiliently deformed table as well, or could even be held self-supporting without a table, except for a position where force is exerted on the first layer 30 to deform the first layer. If the first layer 30 is sufficiently resilient, it may also be held without supporting table a bending of the first layer itself being deformed under influence of the force.

As another example, instead of movement of second layer 32 other forms of relative movement of the layers 30, 32, such as movement of first layer 30 may be used. As another example, instead of a gradual movement of first and second layer 30, 32 towards each other, a controlled temporally increasing force may be used for compressing the layers.

As another example, a non-resilient support of the centre of first layer 30 could be used in combination with a resilient connecting structure between the edges of first layer 30 and second layer 32. In general, to enable deformation, a resilient force should act between a support area where the resilient element 340 or the support supports first layer 30 and withholding areas on the first layer 30 on mutually opposites of the support area.

The shape and location of the support area can be selected dependent on the application. In an embodiment a point shaped, or circular support area in the centre of the layer may be used. In this case the edge of the contact between the layers typically propagates as a circle with increasing radius. Alternatively, a line shaped area extending along the length of the layer may be used. In this case the edges of the contact area between the layers typically propagate from the support area in the form of parallel lines. In another embodiment off centre support may be used.

## Claims

1. A method of manufacturing a multilayer device, the method comprising
- providing a first layer or stack of layers having an exposed surface;
- providing a second layer or stack of layers having an exposed surface;
- applying adhesive to the exposed surface of at least one of the first or second layer or stack of layers;
- providing a resiliently bent structure comprising the first layer or stack of layers bent along its exposed surface;
- bringing the exposed surface of the first and second layer or stack of layers into initial contact at a point or line of tangency along the bend; and
- exerting a temporally increasing force between the first and second layer or stack of layers at least through point or line of tangency, thereby reducing the resilient deformation of the first layer or stack of layers, until the bend of the first layer or stack of layers has been forced out.

2. A method according to claim 1, comprising holding the second layer or stack of layers with its exposed surface flat during exertion of the increasing force.

3. A method according to claim 2, comprising applying the adhesive to the second layer or stack of layers.

4. A method according to claim 3, comprising first mounting the second layer or stack of layers on a holding assembly, and subsequently establish contact between a surface with adhesive and the exposed surface of the second layer or stack of layers on the holding assembly, before bringing the exposed surface of the first and second layer or stack of layers into initial contact.

5. A method according to any one of claims 1 to 4, wherein said providing of the first and/or second layer or stack of layers comprises creating a depression in said the exposed surface of the first or second layers of stack of layers and depositing electrically active material in the depression.

6. An apparatus for joining layers of a multilayer device, the apparatus comprising
- a resilient layer holding assembly for holding and resiliently bending a first layer or stack of layers;
- a holder for holding a second layer stack of layers;
- an actuator coupled between the resilient layer holding assembly and the holder, and configured to bring exposed surfaces of the first and second layer or stack of layers into initial contact at a point or line of tangency along the bend; and to exert a temporally increasing force between the first and second layer or stack of layers at least through point or line of tangency, sufficient to reduce the resilient deformation of the first layer or stack of layers, until the bend of the first layer or stack of layers has been forced out.

7. An apparatus according to claim 6, wherein the resilient layer holding assembly comprises a bendable table with a table surface for supporting the first layer or stack of layers.

8. An apparatus according to claim 6 or 7, wherein suction holes are provided in the table, opening into the table surface.

9. An apparatus according to claim 7 or 8, wherein the resilient layer holding assembly comprises an resiliently compressible element in contact with the a bendable table in an area opposite the table surface.
